# EUROPÄISCHE PATENTANMELDUNG

(11) **EP 2 442 360 A2**
(43) Veröffentlichungstag der Anmeldung: **18.04.2012**
(21) Anmeldenummer: 11185281.0
(22) Anmeldetag: 14.10.2011
(51) Int. Cl.: H01L 27/142, H01L 31/0392, H01L 31/075

(54) **Verfahren zur Herstellung von Verbindungen in einem Dünnschichtfotovoltaikmodul und Dünnschichtfotovoltaikmodul**

(30) Priorität: 15.10.2010 DE 102010048634; 15.10.2010 DE 102010048618
(71) Anmelder: Stein, Wilhelm, 01324 Dresden (DE)
(72) Erfinder: Stein, Wilhelm, 01324 Dresden (DE)
(74) Vertreter: Epping - Hermann - Fischer

(57) **Zusammenfassung**

Ein Verfahren zur Herstellung eines Dünnschichtfotovoltaikmoduls umfasst:
- Bereitstellen eines Schichtstapels mit:
-- einem Substrat (1),
-- einer darauf angeordneten Frontelektrode (2),
-- einem darauf angeordneten Absorber (3),
-- einer darauf angeordneten Rückelektrode (4),

- Aufbringen einer Schicht (8) auf die Rückelektrode (4), die einen Dotierstoff (10) umfasst,
- Aufschmelzen des Rückkontakts (4) und des Absorbers (3) in einem Bereich (20) und dabei verdampfen zumindest eines Teils der Schicht (8), und dadurch
- Ausbilden eines elektrisch leitfähigen Bereichs (31), der die Rückelektrode (4) elektrisch mit der Frontelektrode (2) koppelt.

## Beschreibung

Die Erfindung betrifft ein Verfahren zur Herstellung eines Dünnschichtfotovoltaikmoduls. Die Erfindung betrifft weiterhin ein Fotovoltaikmodul, insbesondere ein Dünnschichtfotovoltaikmodul.

Dünnschichtsolarzellen-Module, auch Dünnschichtfotovoltaikmodule genannt, weisen fotoaktive Schichten mit Schichtdicken in der Größenordnung von Mikrometern auf. Das in der oder den fotoaktiven Schichten eingesetzte Halbleitermaterial kann dabei amorph oder mikrokristallin sein. Auch eine Kombination von Schichten aus amorphen und Schichten aus mikrokristallinem Halbleitermaterial innerhalb einer Zelle ist möglich, zum Beispiel bei den so genannten Tandemzellen und den so genannten Tripelzellen. Als Halbleitermaterialien kommen Si, Ge und Verbindungshalbleiter wie CdTe oder Cu(In, Ga)Se2 (kurz CIS oder CIGS genannt) sowie Verbindungshalbleiter auf III-V-Basis (GaAs) und organische Stoffe zum Einsatz.

Um wirtschaftliche Module mit möglichst großer Fläche einsetzen zu können, ohne dass der in den Elektroden der Solarzellen lateral abgeführte Strom so groß wird, dass hohe ohmsche Verluste auftreten, werden Dünnschichtfotovoltaikmodule üblicherweise in eine Vielzahl von Segmenten unterteilt. Die streifenförmigen und in der Regel einige Millimeter bis Zentimeter breiten Segmente verlaufen dabei meist parallel zu einer Kante des Moduls. Die Segmente werden gebildet, indem bei durchgehendem Substrat einzelne Schichten des Schichtaufbaus der Solarzelle durch dünne Trennlinien unterbrochen werden. Die Trennlinien führen zum einen dazu, dass gleiche Schichten benachbarter Segmente gegeneinander elektrisch isoliert sind und zum anderen dazu, dass nachfolgend aufgebrachte Schichten entlang einer Kontaktierung mit darunter liegenden Schichten elektrisch verbunden werden können. Bei geeigneter Anordnung der Trennlinien lässt sich auf diese Weise eine Reihenschaltung der einzelnen Segmente erreichen. In dem Bereich der Trennlinien wird kein elektrischer Strom erzeugt.

Es ist wünschenswert, ein Verfahren zur Herstellung eines Dünnschichtfotovoltaikmoduls sowie ein Fotovoltaikmodul anzugeben, das möglichst effizient ist.

Gemäß einer Ausführungsform der Erfindung umfasst ein Verfahren zur Herstellung eines Dünnschichtfotovoltaikmoduls ein Bereitstellen eines Schichtstapels. Der Schichtstapel weist ein Substrat, eine darauf angeordnete Frontelektrode, einen darauf angeordneten Absorber und eine darauf angeordnete Rückelektrode auf. Auf die Rückelektrode, insbesondere auf eine Oberfläche der Rückelektrode, die dem Absorber abgewandt ist, wird eine Schicht aufgebracht. Die Schicht umfasst einen Dotierstoff. Der Rückkontakt und der Absorber werden in einem Bereich aufgeschmolzen. Dabei wird zumindest ein Teil der Schicht verdampft. Dadurch wird ein elektrisch leitfähiger Bereich ausgebildet, der die Rückelektrode elektrisch mit der Frontelektrode koppelt.

Das Aufbringen der Schicht umfasst gemäß Ausführungsformen das Aufbringen einer Flüssigkeit, die den Dotierstoff umfasst.

Das Aufbringen der Schicht umfasst gemäß Ausführungsformen das Aufbringen eines Pulvers, das den Dotierstoff umfasst.

Das Aufbringen der Schicht umfasst gemäß Ausführungsformen das Aufbringen eines Festkörpers, der den Dotierstoff umfasst, beispielsweise dotierstoffhaltiges Glas, insbesondere phosphorhaltiges Gas.

Durch das Aufschmelzen des Rückkontakts und des Absorbers und dem gleichzeitigen Verdampfen eines Teils der Schicht wird ein elektrisch leitfähiger Bereich ausgebildet, der die Frontelektrode durch den Absorber mit der Rückelektrode koppelt. Durch die Anreicherung dieses Bereichs mit dem Dotierstoff aus der Schicht wird die elektrische Leitfähigkeit in diesem Bereich erhöht. Beispielsweise weist der Bereich im Falle von Siliziumabsorbern einen Schichtwiderstand von bis zu 1 Ohm/square auf.

Gemäß weiteren Ausführungsformen werden der Rückkontakt und der Absorber durch ein Einstrahlen von Laserlicht aufgeschmolzen und der Teil der Schicht durch das Laserlicht verdampft. Dadurch kann einfach der elektrisch leitfähige Bereich ausgebildet werden. Insbesondere wird der elektrisch leitfähige Bereich, der die Frontelektrode elektrisch mit der Rückelektrode koppelt mit Hilfe des Laserstahls ausgebildet, nachdem sowohl die Frontelektrode und der Absorber als auch die Rückelektrode abgeschieden wurden.

Gemäß weiteren Aspekten wird der Rückkontakt und der Absorber beim Aufschmelzen in dem Bereich derart aufgeheizt, dass sich die physikalischen Eigenschaften mindestens einer der Schichten, insbesondere ihre Leitfähigkeit, in dem Bereich verändern. Insbesondere wird in dem Bereich die elektrische Leitfähigkeit des Absorbers verändert. Die elektrische Leitfähigkeit ist in dem Bereich der aufgeschmolzen wurde höher als in Bereichen des Absorbers außerhalb des ausgebildeten elektrisch leitfähigen Bereichs. Die Leitfähigkeit des ausgebildeten elektrisch leitfähigen Bereichs wird insbesondere dadurch erhöht, dass sich der Dotierstoff aus der Flüssigkeit in dem elektrisch leitfähigen Bereich anordnet. In dem Bereich bildet sich eine Materialverbindung aus, die von den ursprünglichen Materialien, insbesondere den Materialien des Absorbers und der Rückelektrode, abweichende physikalische Eigenschaften hat. Die Materialverbindung ist insbesondere aus einer Schmelze der unterschiedlichen Materialien des Dotierstoffs, der Rückelektrode und des Absorbers gebildet. Somit ist die Konzentration an Dotierstoff, insbesondere an Elektronen-Donatoren, in dem ausgebildeten elektrisch leitfähigen Bereich erhöht im Vergleich zu einem Materialgemisch das lediglich aus Material der Rückelektrode und des Absorbers bestehen würde. Dadurch wird die elektrische Leitfähigkeit in dem ausgebildeten elektrisch leitfähigen Bereich im Vergleich zu dem übrigen Absorber erhöht, ohne dass auf den restlichen Bereich des Schichtstapels Einfluss genommen wird.

Gemäß weiteren Aspekten weist die Schicht einen Dotierstoff des Absorbers auf. Bei einem Siliziumabsorber wird beispielsweise Phosphor als Dotierstoff in der Schicht verwendet. Beispielsweise ist die Flüssigkeit Phosphorsäure. Die Schicht umfasst einen Dotierstoff, der die Leitfähigkeit des Materials des Absorbers erhöht, wenn das Material des Absorbers mit dem Dotierstoff dotiert ist.

Gemäß einer Ausführungsform der Erfindung umfasst ein Fotovoltaikmodul mindestens ein erstes und ein zweites Segment. Das erste und das zweite Segment sind elektrisch in Reihe geschaltet. Das Fotovoltaikmodul umfasst eine Frontelektrode, einen darauf angeordneter Absorber und eine auf dem Absorber angeordnete Rückelektrode. Das Fotovoltaikmodul weist eine elektrische Isolierung auf, die zwischen dem ersten und dem zweiten Segment angeordnet ist und die zumindest die Rückelektrode unterbricht. Das Fotovoltaikmodul weist eine Kontaktierung auf, über die die Rückelektrode mit der Frontelektrode zur Reihenschaltung des ersten und des zweiten Segments elektrisch gekoppelt ist. Die Kontaktierung enthält im Bereich des Absorbers eine leitfähige Materialverbindung und/oder ein leitfähige Legierung aus Elementen des Absorbers, der Rückelektrode und eines Dotierstoffs.

Insbesondere weist die Kontaktierung eine höhere Konzentration an Elektronen-Donatoren auf als der Absorber. Beispielsweise weist der Absorber Silizium auf und die Kontaktlinie weist eine höhere Konzentration an Phosphor auf als der Absorber.

Gemäß weiteren Ausführungsformen weist die Kontaktierung eine höhere Konzentration an Löcher-Akzeptoren (e⁻-Akzeptoren) auf als der Absorber.

### Kurze Beschreibung der Zeichnungen

Weitere Vorteile, Merkmale und Weiterbildungen ergeben sich aus den nachfolgenden in Verbindung mit den Figuren erläuterten Beispielen. Gleiche, gleichartige und gleich wirkende Elemente können in den Figuren mit den gleichen Bezugszeichen versehen sein. Die dargestellten Elemente und deren Größenverhältnisse zueinander sind grundsätzlich nicht als maßstabsgerecht anzusehen, vielmehr können einzelne Elemente, wie beispielsweise Bereiche oder Schichten zum besseren Verständnis übertrieben groß oder dick dimensioniert dargestellt sein.

Es zeigen:
Figur 1 eine schematische Darstellung eines Fotovoltaikmoduls gemäß einer Ausführungsform,
Figuren 2A bis 2E schematische Darstellungen eines Schichtaufbaus eines Dünnschichtfotovoltaikmoduls, jeweils zu verschiedenen Verfahrensstadien während der Herstellung gemäß einer Ausführungsform,
Figur 3 eine schematische Darstellung eines Fotovoltaikmoduls gemäß einer Ausführungsform,
Figur 4 ein Flussdiagramm eines Verfahrens zur Herstellung von Fotovoltaikmodulen gemäß einer Ausführungsform.

### Detaillierte Beschreibung von Ausführungsformen

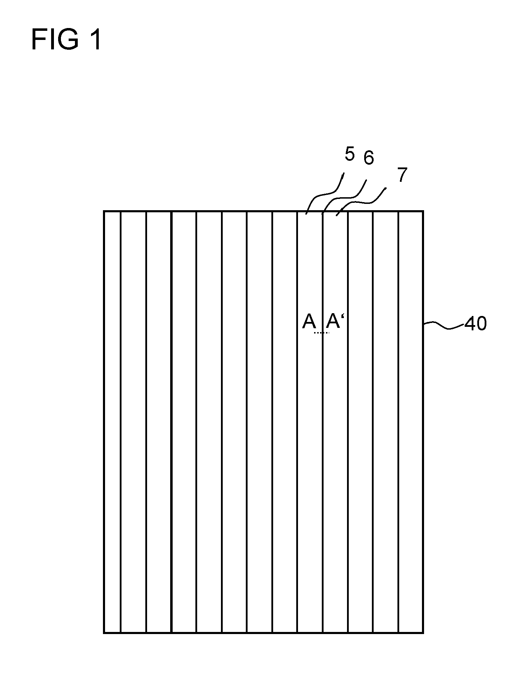

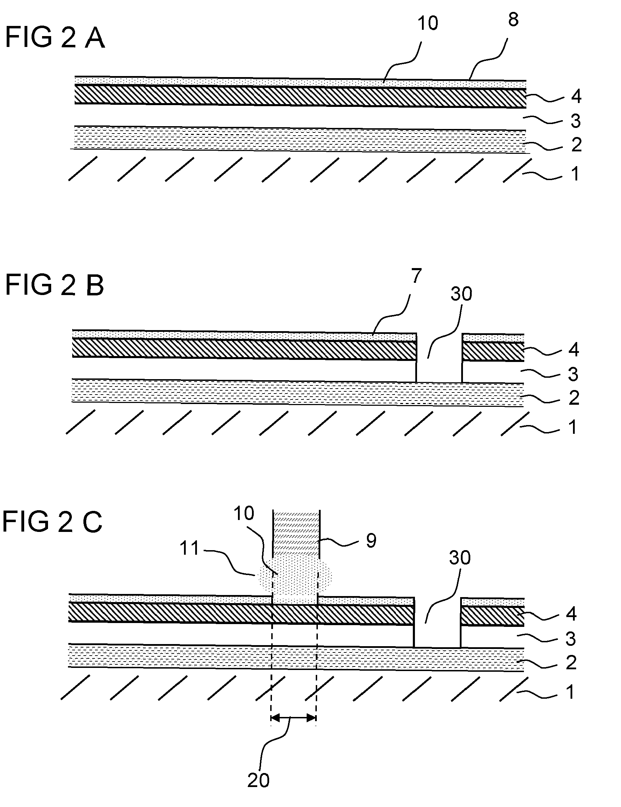

Figur 1 zeigt schematisch ein Ausführungsbeispiel eines Fotovoltaikmoduls 40, das eingerichtet ist, im betriebsfertigen Zustand Strahlungsenergie in elektrische Energie umzuwandeln. Das Fotovoltaikmodul 40 ist vom Typ eines Dünnschichtfotovoltaikmoduls, auch Dünnfilmfotovoltaikmodul genannt. Das Fotovoltaikmodul 40 weist eine Mehrzahl von Segmenten 5, 7 auf, die auf einem gemeinsamen Substrat 1 (Figur 2A) angeordnet sind. Jeweils zwei unmittelbar nebeneinander angeordnete Segmente, beispielsweise die Segmente 5 und 7, sind durch eine Trennlinie beziehungsweise durch einen Kontaktierungsbereich getrennt, beispielsweise ist zwischen den Segmenten 5 und 7 ein Kontaktierungsbereich 6 angeordnet. Das Fotovoltaikmodul 40 ist beispielsweise ein Siliziumdünnschichtfotovoltaikmodul, ein CIS-Dünnschichtfotovoltaikmodul, ein CdTe-Dünnschichtfotovoltaikmodul oder ein III-V-Dünnschichtfotovoltaikmodul. Das Fotovoltaikmodul 40 ist gemäß weiteren Ausführungsformen ein Fotovoltaikmodul, das organische Materialien umfasst.

Figur 2A zeigt eine schematische Darstellung durch einen Schichtstapel eines Dünnschichtfotovoltaikmoduls zu einem Verfahrenszeitpunkt der Herstellung des Dünnschichtfotovoltaikmoduls. Auf dem flächig ausgedehnten Substrat 1 ist quer zur Hauptausbreitungsrichtung des Substrats 1 eine elektrisch leitfähige Schicht 2 angeordnet. Die elektrisch leitfähige Schicht 2 dient in betriebsfertigem Zustand als Frontelektrode des Fotovoltaikmoduls. Auf einer dem Substrat 1 abgewandten Oberfläche der Frontelektrode 2 ist Absorber 3 angeordnet. Auf der dem Substrat 1 abgewandten Oberfläche des Absorbers 3 ist eine weitere elektrisch leitfähige Schicht 4 angeordnet. Die weitere elektrisch leitfähige Schicht 4 dient in betriebsfertigem Zustand als Rückelektrode. Auf der dem Substrat abgewandten Oberfläche der Rückelektrode 4 ist eine Schicht 8 aufgebracht. Die Schicht weißt einen Dotierstoff 10 auf.

Die Schicht 8 wird gemäß Ausführungsformen nach Abschluss der Segmentierung wieder von der Oberfläche der Rückelektrode 4 entfernt. In einem betriebsfertigen Fotovoltaikmodul ist die Schicht 8 für die Umwandlung von Strahlungsenergie in elektrische Energie sowie die Abführung des elektrischen Stroms beziehungsweise der elektrischen Spannung nicht notwendig.

Die Schicht 8 wird gemäß Ausführungsformen von einer Flüssigkeit gebildet. Die Schicht wird gemäß Ausführungsformen von einem Pulver gebildet. Die Schicht wird gemäß Ausführungsformen von einem Festkörper gebildet. Nachfolgend wird das Verfahren anhand einer Flüssigkeitsschicht 8 erläutert. Diese Erläuterungen gelten genauso für Pulverschichten und Festkörperschichten.

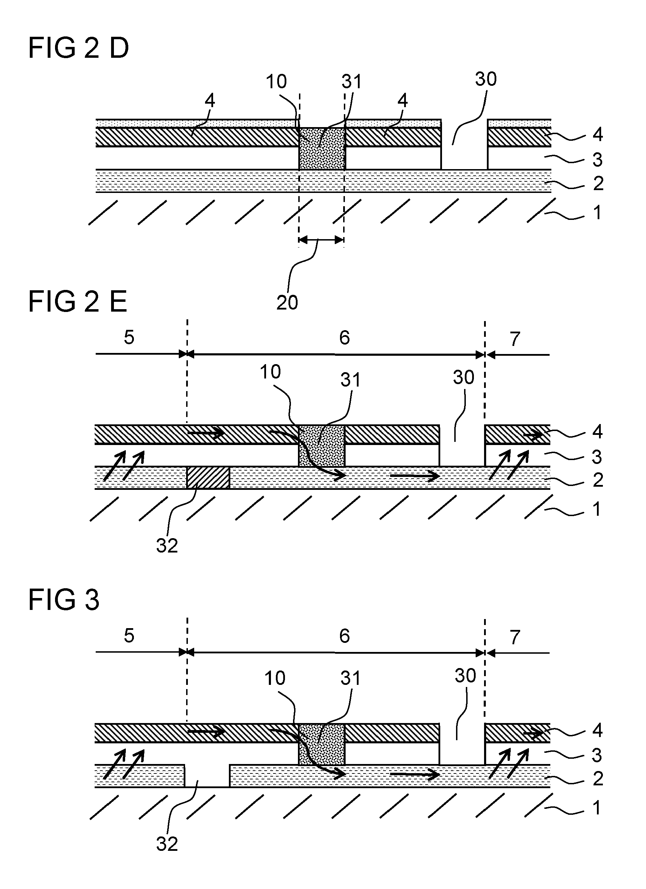

Die Flüssigkeit ist gemäß Ausführungsformen vollflächig auf die weitere elektrisch leitfähige Schicht 4 aufgebracht. Gemäß weiteren Ausführungsformen ist die Flüssigkeit nur bereichsweise auf die Oberfläche der weiteren elektrisch leitfähigen Schicht 4 aufgebracht, insbesondere in einem Bereich 20 (vergleiche Figur 2D).

Beispielhaft handelt es sich bei dem Substrat 1 um Flachglas, bei der ersten elektrisch leitfähigen Schicht 2 um eine Frontseitenelektrode aus TCO (TCO = Transparent Conductive Oxide Layers; transparente leitfähige Oxidschicht) und bei dem Absorber 3 um eine photoaktive Schichtfolge mit einer Abfolge von p-dotiertem, im Wesentlichen intrinsischem und n-dotiertem amorphen oder mikrokristallinem Silizium. Die erste elektrisch leitfähige Schicht 2 und die photoaktive Schichtfolge 3 können in aufeinanderfolgenden Vakuumbeschichtungsprozessen aufgebracht sein, ohne dass das Substrat 1 dazu aus dem Vakuum geschleust werden muss. Ebenso ist es möglich, mit einem Substrat 1 zu starten, das bereits mit einer TCO-Schicht als erste elektrisch leitfähige Schicht 2 versehen ist. In diesem Fall ist nur die photoaktive Schichtfolge 3 aufzubringen. Gemäß weiteren Ausführungsformen werden die erste elektrisch leitfähige Schicht 2, der Absorber 3 und die weitere elektrisch leitfähige Schicht 4 in aufeinanderfolgenden Vakuumbeschichtungsprozessen aufgebracht, ohne dass das Substrat 1 dazu aus dem Vakuum geschleust werden muss.

Die im Betrieb der Sonne zugewandte erste elektrisch leitfähige Schicht 2, die die Frontelektrode ausbildet, umfasst beispielsweise SnO2, ZnO oder ITO. Die im Betrieb der Sonne abgewandte zweite elektrisch leitfähige Schicht, die die Rückelektrode ausbildet, kann ebenfalls eine TCO-Schicht aufweisen oder auch durch Metalle wie Ag, Al, Mo oder aus Kombinationen von TCO und einer Metallschicht ausgebildet sein.

Der Absorber 3 umfasst typischerweise zumindest eine p- und eine n-dotierte Halbleiterschicht. Im Falle von Dünnschichtfotovoltaikzellen auf der Basis von Silizium werden die p- und die n-dotierten Schichten üblicherweise noch durch eine ausgedehnte im Wesentlichen intrinsische (also undotierte) Schicht (i-Schicht) getrennt. Zur besseren Ausnutzung des Wellenlängenspektrums können mehrere pin-Schichtenfolgen mit unterschiedlichen Absorberspektren übereinander in dem Absorber 3 vorgesehen sein. Eine solche Siliziumtandemzelle weist beispielsweise eine pin-Schichtfolge aus amorphem Silizium und eine pin-Schichtfolge aus mikrokristallinem Silizium auf. Es kann auch eine weitere pin-Schichtenfolge aus amorphem Siliziumgermanium vorgesehen sein. In diesem Fall spricht man von Triplezellen.

Typischerweise ist die p-dotierte Schicht im Betrieb des Fotovoltaikmoduls der Sonne zugewandt. Es ist auch möglich, dass die n-dotierte Schicht der Sonne zugewandt ist. Als Aufwachssubstrat wird Glas oder auch eine (Metall-)Folie eingesetzt. Das Trägersubstrat, durch das im Betrieb das Sonnenlicht einfällt, wird bei Verwendung einer (Metall-) Folie erst am Ende des Herstellungsprozesses auf das Modul auflaminiert. Der Schichtstapel bleibt dabei mit dem Aufwachssubstrat verbunden.

Als aktives Halbleitermaterial für den Absorber 3 können amorphe oder mikrokristalline Halbleiter der Gruppe 4, zum Beispiel a-Si, a-SiGe, µC-Si, oder Verbindungshalbleiter wie zum Beispiel CdTe oder Cu(In, Ga)Se2 (kurz CIS oder CIGS genannt) eingesetzt werden. Weiterhin kann der Absorber organisches Material umfassen, das eingerichtet ist, Strahlungsenergie in elektrische Energie umzuwandeln. Dabei können in dem Absorber 3 auch Schichten verschiedener der genannten Materialien kombiniert werden. Weiterhin können in dem Absorber 3 teilweise spiegelnde Schichten (intermediate reflectors) aus einem leitfähigen Oxid und/oder einer leitfähigen Halbleiterschicht vorgesehen sein.

Der Dotierstoff 10 der Flüssigkeit ist insbesondere ein Elektronen-Donator. Gemäß weiteren Ausführungsformen ist der Dotierstoff 10 ein Elektronen-Akzeptor. Der Dotierstoff 10 wird in Abhängigkeit des verwendeten Materials des Absorbers 3 ausgewählt. Der Dotierstoff 10 wird so ausgewählt, dass er ein Dotierstoff des Absorbers 3 ist. Das Material des Absorbers 3 weist eine höhere elektrische Leitfähigkeit auf, wenn es mit dem Dotierstoff 10 dotiert ist. Bei einem Absorber 3 aus Silizium wird als Dotierstoff 10 beispielsweise Phosphor verwendet. Die Flüssigkeit 8 ist beispielsweise Phosphorsäure. Die Flüssigkeit 8 wird auf die Rückelektrode 4 aufgebracht, nachdem die Frontelektrode 2, der Absorber 3 und die Rückelektrode 4 vollständig abgeschieden sind. Insbesondere wird die Flüssigkeit 8 auf die Rückelektrode 4 aufgebracht, bevor die Frontelektrode 2, der Absorber 3 und die Rückelektrode 4 strukturiert werden, um die Segmente 5 und 7 und den Kontaktierungsbereich 6 auszubilden.

Figur 2B zeigt einen weiteren Verfahrensschritt. Eine elektrische Isolierung 30 ist in die Rückelektrode 4 und den Absorber 3 eingebracht worden. Gemäß weiteren Aspekten ist die Isolierung 30 nur in die Rückelektrode 4 eingebracht. Die elektrische Isolierung 30 trennt die Rückelektrode 4 so, dass die zwei angrenzenden Bereiche der Rückelektrode 4 beidseitig der elektrischen Isolierung 30 elektrisch voneinander getrennt sind. Die Isolierung 30 ist im gezeigten Ausführungsbeispiel eine Ausnehmung der Rückelektrode 4 und dem Absorber 3.

Figur 2C zeigt schematisch einen Verfahrensschritt zur Herstellung einer Kontaktierung 31 (Figur 2D) zur elektrischen Kontaktierung der Rückelektrode 4 mit der Frontelektrode 2.

Ein Laserstrahl 9 wird auf den Bereich 20 aus Richtung der Rückelektrode eingestrahlt. Durch den Laserstrahl 9 wird die Flüssigkeit 8 mit dem Dotierstoff 9 in dem Bereich 20 verdampft, so dass sich Dampf 11 mit dem Dotierstoff 10 ausbildet.

Durch den Laserstrahl 9 wird die Rückelektrode 4 und der Absorber 3 in dem Bereich 20 aufgeschmolzen.

Figur 2D zeigt den Verfahrensschritt nach der Einstrahlung des Laserstrahls 9.

In dem Bereich 20 hat sich die Kontaktierung 31 ausgebildet, die aus Richtung der Rückelektrode von der Rückelektrode durch den Absorber 3 bis zu der Frontelektrode 2 reicht.

Die Kontaktierung 31 ist gebildet aus der Schmelze der Rückelektrode 4 und des Absorbers 3 der Figur 2C. Gemäß weiteren Ausführungsformen umfasst die Schmelze zusätzlich Material der Frontelektrode 2. Weiterhin hat sich in die Schmelze Dotierstoff 10 aus dem Dampf 11 der Figur 2C eingelagert. Der Dotierstoff 10 der sich in der Figur 2C in einer Dampfwolke über der Rückelektrode 4 befindet wird beim Wiedererstarren in die Materialverbindung in dem Bereich 20 aus dem Material des Absorbers 3 und Material der Rückelektrode 4 eingebaut. Dadurch entsteht der elektrisch hochleitfähige Kontaktbereich 31. Der Kontaktbereich 31 weist einen Schichtwiderstand von bis zu 1 Ohm/square auf. Durch die Kontaktierung 31 besteht ein ohmscher Kontakt zwischen der Rückelektrode 4 und der Frontelektrode 2. Die Kontaktierung 31 reicht von einer dem Substrat abgewandten Oberfläche der Rückelektrode 4 bis zu der Frontelektrode 2. Gemäß weiteren Ausführungsformen reicht die Kontaktierung 31 von einer dem Substrat abgewandten Oberfläche der Rückelektrode 4 bis zu dem Substrat 1, so dass der elektrische Kontakt dann lateral zur benachbarten nichtgeschmolzenen Frontelektrode 2 ist.

Die Konzentration an dem Dotierstoff 10 in der Kontaktierung 31 ist höher als die Konzentration des Dotierstoffs in dem Absorber 3 außerhalb des Bereichs 20. Durch das Einbauen des Dotierstoffs 10 aus der Flüssigkeit 8 in die Kontaktierung 31 wird die Leitfähigkeit der Kontaktierung 31 erhöht. Insbesondere ist die Leitfähigkeit der Kontaktierung 31 dadurch im Vergleich zu einer Materialverbindung erhöht, die lediglich aus Material der Rückelektrode 4 und dem Absorber 3 besteht. Das Material der Rückelektrode 4 ist elektrisch leitfähig. Beim Ausbilden der Schmelze und dem Materialgemisch aus dem Material des Absorbers 3 und der Rückelektrode 4 ist ein genügend hoher Anteil an elektrisch leitfähigem Material aus der Rückelektrode 4 in Bezug auf Material des Absorbers nicht gewährleistet. Durch das zusätzliche Einlagern des Dotierstoffs 10 über die zusätzliche Flüssigkeit 8 wird eine zuverlässige elektrische Leitfähigkeit der Kontaktierung 31 gewährleistet.

Figur 2E zeigt einen Ausschnitt eines fertig strukturierten Fotovoltaikmoduls. Die Segmente 5 und 7 dienen zur Umwandlung von Strahlungsenergie aus der Sonne in elektrische Energie. Der Kontaktierungsbereich weist die elektrische Isolierung 30 und die Kontaktierung 31 auf. Die übrige Flüssigkeit 8 wurde von der Oberfläche der Rückelektrode 4 entfernt.

Eine Trennlinie 32 wurde in die Frontelektrode 2 eingebracht, um die Frontelektrode 2 zwischen den Segmenten 5 und 7 elektrisch zu isolieren. Gemäß Ausführungsformen wird die Trennlinie 32 in die Frontelektrode 2 eingebracht, nachdem sowohl die Frontelektrode als auch der Absorber 3 und die Rückelektrode 4 vollständig abgeschieden wurden. Beispielsweise wird die Trennlinie 32 durch Einstrahlen von einem Laserstrahl in die Frontelektrode 2 eingebracht. Die Leistung der Laserstrahlung und die Bearbeitungszeit wird so gewählt, dass die Frontelektrode 2 lokal erwärmt wird und zu Rekristallationsprozessen angeregt wird. Dadurch hervorgerufene Veränderung der Mikrostruktur des Materials der Frontelektrode 2 führt zu einer deutlichen Herabsetzung ihrer Leitfähigkeit.

Die Reihenfolge der Einbringung der elektrischen Isolierung 30, der Kontaktierung 31 und der Trennlinie 32 kann auch anders sein als in Verbindung mit den Figuren 1A bis 1E erläutert. Beispielsweise wird zuerst die elektrische Kontaktierung 31 ausgebildet. Daraufhin wird die Flüssigkeit 8 von der Rückelektrode 4 entfernt und dann die elektrische Isolierung 30 ausgebildet.

Die Schritte zur Strukturierung der Schichten 2, 3 und 4 in dem Kontaktierungsbereich 6 führen zu einer Serienverschaltung der beiden Segmente 5 und 7, wie durch die den Stromverlauf symbolisierenden Pfeile in der Figur 2E ersichtlich.

Figur 3 zeigt schematisch eine Schnittansicht entlang der Linie A-A' der Figur 1 wie in Zusammenhang mit den Figuren 2A bis 2E erläutert.

Im Unterschied zu der Figur 2E weist die Trennlinie 32 im Ausführungsbeispiel gemäß der Figur 3 Material des Absorbers 3 auf. Zur elektrischen Isolierung der Frontelektrode 2 links und rechts von der Trennlinie 32 wird eine Ausnehmung im Bereich der Trennlinie 32 in die erste elektrisch leitfähige Schicht 2 eingebracht, bevor der Absorber auf der ersten elektrisch leitfähigen Schicht 2 angeordnet wird. Während des Aufbringens des Absorbers 3 auf der ersten elektrisch leitfähigen Schicht 2 setzt sich dann das Material des Absorbers 3 in dieser Ausnehmung ab und wirkt elektrisch isolierend. Die Trennlinie 32 ist aus Material des Absorbers 3 gebildet.

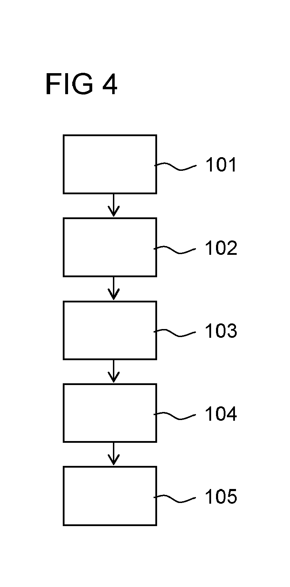

Figur 4 zeigt ein Flussdiagramm eines Verfahrens zur Herstellung eines Fotovoltaikmoduls wie im Zusammenhang mit den Figuren 1 bis 3 erläutert.

In Schritt 101 wird das Substrat 1 bereitgestellt. Die Frontelektrode 2 sowie die Schichten des Absorbers 3 und die Rückelektrode 4 werden nacheinander auf das Substrat 1 aufgebracht.

In einer Ausführungsform wird eine Ausnehmung im Bereich der Trennlinie 32 in die Frontelektrode 2 eingebracht, bevor der Absorber 3 aufgebracht wird.

Gemäß weiteren Ausführungsformen werden die Frontelektrode 2, der Absorber 3 und die Rückelektrode 4 jeweils vollflächig aufgebracht, ohne dazwischen liegende Strukturierungsschritte.

Üblicherweise werden die elektrisch leitfähigen Schichten 2 und 4 und der Absorber 3 bei Dünnschichtsolarmodulen in Vakuumprozessen auf das Substrat 1 aufgebracht. Hierfür eignen sich PVD-Prozesse (Physical Vapor Deposition) wie zum Beispiel Plasmasputtern oder Elektrodenstrahlverdampfen oder auch CVD-Prozesse (Chemical Vapor Deposition) wie zum LPCVD (Low Pressure CVD) oder PECVD (Plasma Enhanced CVD).

In Schritt 102 wird die Flüssigkeit 8 auf die Rückelektrode aufgebracht. Beispielsweise wird die Flüssigkeit 8 aufgesprüht.

Gemäß Ausführungsformen wird die Flüssigkeit 8 auf die gesamte oder nahezu gesamte Fläche der Rückelektrode 4 aufgebracht. Gemäß weiteren Ausführungsformen wird die Flüssigkeit lediglich auf die Bereiche der Rückelektrode 4 aufgebracht, in denen nachfolgend die Kontaktierung 31 ausgebildet werden soll, also beispielsweise in Bereichen, die mit dem Kontaktierungsbereich 6 korrespondieren.

Nachfolgend wird in Schritt 103 ein Laserlicht eingestrahlt. Gemäß Ausführungsformen wird das Laserlicht aus Richtung des Substrats 1 eingestrahlt. Gemäß weiteren Ausführungsformen wird das Laserlicht aus Richtung der Rückelektrode 4 eingestrahlt. Durch das Laserlicht wird der Absorber 3 und der Rückkontakt 4 in dem Bereich 20 aufgeschmolzen. Durch das Laserlicht wird weiterhin der Teil der Flüssigkeit 8 verdampft, der im Bereich 20 auf der Rückelektrode 4 liegt. Beispielsweise wird Laserlicht einer Wellenlänge aus einem Bereich von beispielsweise 200 nm bis 10 µm verwendet. Es wird Laserlicht einer Wellenlänge verwendet und über einen Zeitraum eingestrahlt, so dass die Rückelektrode 4 und der Absorber 3 lokal begrenzt aufgeschmolzen, aber nicht verdampft werden.

Nach dem das Einstrahlen des Laserlichts beendet wurde bildet sich die Materialverbindung aus Material des Absorbers 3 der Rückelektrode 4 und dem Dotierstoff 10 aus der Flüssigkeit 8. Dadurch bildet sich im Bereich der Kontaktierung 31 ein ohmscher Kontakt zwischen der Rückelektrode 4 und der Frontelektrode 2. Dadurch kann an dieser Stelle im Betrieb Strom von der Rückelektrode 4 in die Frontelektrode 2 fließen.

In Schritt 104 wird die elektrische Isolierung 30 zwischen dem ersten Segment 5 und dem zweiten Segment 7 in die Rückelektrode 4 und den Absorber 3 eingebracht. Beispielsweise wird die Ausnehmung 30 durch Einbringen von Laserstrahlung einer Wellenlänge von 532 nm erzeugt.

In Schritt 105 wird die Trennlinie 32 zur Unterbrechung der Frontelektrode 2 ausgebildet. Dazu wird Laserstrahlung einer Wellenlänge, die in der ersten elektrisch leitfähigen Schicht absorbiert wird, zum Beispiel 1064 nm, durch das Substrat 1 eingebracht. Die Leistung der Laserstrahlung und die Bearbeitungszeit werden so gewählt, dass die Frontelektrode 2 lokal erwärmt und zu Rekristallationsprozessen angeregt wird. Die dadurch hervorgerufene Veränderung der Mikrostruktur des Materials der Frontelektrode 2 führt zu einer deutlichen Herabsetzung ihrer Leitfähigkeit. Grund ist beispielsweise, dass für die Leitfähigkeit von TCO-Schichten im Wesentlichen die Dotierstoffe verantwortlich sind, die als Folge des Rekristallationsprozesses nicht mehr im Kristall eingebaut sind. Gemäß weiteren Ausführungsformen ist auch eine Vollisolierung des gesamten Schichtstapels möglich mit elektrischer Überbrückung der Trennung im Rückkontakt mit Tintenstrahltechnik mit silberhaltiger Tinte.

In der Ausführungsform, in der die Ausnehmung im Bereich der Trennlinie 32 in die erste elektrisch leitfähig Schicht 2 eingebracht wurde, bevor der Absorber 3 aufgebracht wird, wird die elektrisch isolierende Trennlinie 32 dadurch ausgebildet, dass sich Material der photoaktiven Schichtfolge 3 in der Ausnehmung absetzt. Auf Schritt 105 kann in diesen Ausführungsformen verzichtet werden.

Die Reihenfolge der Strukturierungsschritte 103, 104 und 105 kann beliebig vertauscht werden. Beispielsweise kann Schritt 105 vor Schritt 103 erfolgen.

Zumindest die Strukturierungsmaßnahmen zur Ausbildung der elektrischen Isolierung 30 und zur Ausbildung der Kontaktierung 31 sind in einem Ausführungsbeispiel von einem einzigen Prozesskopf ausgeführt. Gemäß weiteren Ausführungsformen werden alle drei Strukturierungsschritte, also die Strukturierungsmaßnahmen zur Ausbildung der elektrischen Isolierung 30, zur Ausbildung der Kontaktierung 31 und zur Ausbildung der Trennlinie 32 gemäß Figur 2B von einem einzigen Prozesskopf ausgeführt. So kommt es zwischen der elektrischen Isolierung 30 und der Kontaktierung 31 und der Trennlinie 32 bei der Herstellung zu keinen Toleranzschwankungen, die berücksichtigt werden müssten. Gemäß weiteren Ausführungsformen werden die Strukturierungsmaßnahmen zur Ausbildung der elektrischen Isolierung 30, zur Ausbildung der Kontaktierung 31 und zur Ausbildung der Trennlinie 32 gemäß Figur 2B von mehreren Prozessköpfen ausgeführt, die an einer gemeinsamen Strukturierungsanlage angeordnet sind.

Bei dem Fotovoltaikmodul wie im Zusammenhang mit den Figuren 1 bis 3 erläutert sowie dem Verfahren zur Herstellung von Fotovoltaikmodulen wie in Verbindung mit Figur 4 erläutert sind die elektrisch leitfähigen Schichten 2 und 4 und die photoaktiven Schichtfolgen des Absorbers 3 derart strukturiert, dass eine Reihenverschaltung ausgeführt werden kann, nachdem bereits mindestens zwei der Schichten auf das Substrat aufgebracht wurden. Insbesondere werden die Schichten 2, 3 und 4 derart strukturiert, dass die Reihenverschaltung ausgeführt werden kann, nachdem bereits alle Schichten der Schichten 2, 3 und 4 auf das Substrat aufgebracht wurden. Die Zusammenfassung der Prozessschritte zum Aufbringen der Schichten resultiert insbesondere bei Dünnschichtfotovoltaikmodulen in geringeren Verunreinigungen, zum Beispiel durch häufiges Ein- und Ausschleusen in und aus Vakuumkammern, und somit in einer besseren Schichtqualität, aus der sich eine höhere Effizienz der Zelle ergibt.

Darüber hinaus können bei den vorgestellten Fotovoltaikmodulen die Prozessschritte zum Strukturieren von Schichten zusammengefasst werden, was eine bessere Positionierung der Strukturierungsmaßnahme in den verschiedenen Schichten zueinander führt. Dadurch ergibt sich ein in Hauptausbreitungsrichtung der Schichten kleinerer Kontaktbereich 6 für die Reihenverschaltung und folglich ein höherer Flächenertrag des Fotovoltaikmoduls. Zudem ist der Herstellungsprozess zeitlich effektiver, wenn weniger Einund Ausschleuseprozesse durchgeführt werden müssen und Strukturierungsmaßnahmen in einem gemeinsamen Prozesskopf zusammengeführt werden. Dies führt auch zu einer Kosteneinsparung, sowohl bei den Herstellungsanlagen, als auch während der Produktion. Auch wird für die Herstellungsanlagen weniger Fläche benötigt. Auf zusätzliche Reinigungsschritte zwischen den einzelnen Beschichtungsprozessen kann verzichtet werden. Damit kann auch dann auf die dafür notwendigen Produktionsanlagen verzichtet werden.

## Patentansprüche

1. Verfahren zur Herstellung eines Dünnschichtfotovoltaikmoduls, umfassend:
- Bereitstellen eines Schichtstapels mit:
-- einem Substrat (1),
-- einer darauf angeordneten Frontelektrode (2),
-- einem darauf angeordneten Absorber (3),
-- einer darauf angeordneten Rückelektrode (4),
- Aufbringen einer Schicht (8) auf die Rückelektrode (4), die einen Dotierstoff (10) umfasst,
- Aufschmelzen des Rückkontakts (4) und des Absorbers (3) in einem Bereich (20) und dabei verdampfen zumindest eines Teils der Schicht (8), und dadurch
- Ausbilden eines elektrisch leitfähigen Bereichs (31), der die Rückelektrode (4) elektrisch mit der Frontelektrode (2) koppelt.

2. Verfahren nach Anspruch 1, bei dem der Rückkontakt (4) und der Absorber (3) durch ein Einstrahlen von Laserlicht (9) aufgeschmolzen werden und der Teil der Schicht (8) durch das Laserlicht verdampft wird.

3. Verfahren nach Anspruch 1 oder 2, bei dem beim Aufschmelzen die Rückelektrode (4) und der Absorber (3) in dem Bereich (20) derart aufgeheizt werden, dass sich die physikalischen Eigenschaften mindestens einer der Schichten, insbesondere ihre Leitfähigkeit, in dem Bereich (20) verändern.

4. Verfahren nach Anspruch 3, bei dem übereinander liegende Schichten (3, 4, 8) aus unterschiedlichen Materialien lokal aufgeheizt werden und sich eine Materialverbindung (31) ausbildet, die von den ursprünglichen Materialien abweichende physikalische Eigenschaften hat und insbesondere leitfähig ist.

5. Verfahren nach Anspruch 4, bei dem in dem Bereich (20) eine Schmelze der unterschiedlichen Materialien des Dotierstoffs (10), der Rückelektrode (4) und des Absorbers (3) gebildet wird und bei dem aus der Schmelze die Materialverbindung entsteht.

6. Verfahren nach einem der Ansprüche 1 bis 5, bei dem die Schicht (8) einen Dotierstoff (10) des Absorbers (3) aufweist.

7. Verfahren nach einem der Ansprüche 1 bis 6, bei dem das Aufbringen der Schicht (8) ein Aufbringen zumindest eines aus einer Flüssigkeit, eines Pulvers und eines Feststoffs umfasst.

8. Verfahren nach einem der Ansprüche 1 bis 7, bei dem die Schicht (8) Phosphorsäure und/oder phosphorhaltiges Glas aufweist.

9. Dünnschichtfotovoltaikmodul, umfassend:
- mindestens ein erstes (5) und ein zweites (7) Segment, die elektrisch in Reihe geschaltet sind,
- eine Frontelektrode (2),
- einen darauf angeordneter Absorber (3),
- eine darauf angeordneter Rückelektrode (4),
- eine elektrische Isolierung (30), die zwischen dem ersten (5) und dem zweiten (7) Segment angeordnet ist und die zumindest die Rückelektrode (4) unterbricht,
- eine Kontaktierung (31), über die die Rückelektrode(4) mit der Frontelektrode (2) zur Reihenschaltung des ersten (5) und des zweiten (7) Segments elektrisch gekoppelt ist, wobei die Kontaktierung (31) im Bereich des Absorbers (3) eine leitfähige Materialverbindung und/oder ein leitfähige Legierung aus Elementen des Absorbers (3), der Rückelektrode (4) und eines Dotierstoffs (10) enthält.

10. Dünnschichtfotovoltaikmodul nach Anspruch 9, bei dem die Kontaktierung (31) eine höhere Konzentration an Elektronen-Donatoren oder Löcher-Akzeptoren aufweist als der Absorber (3).

11. Dünnschichtfotovoltaikmodul nach Anspruch 9 oder 10, bei dem der Absorber (3) Silizium aufweist und bei dem die Kontaktlinie (31) eine höhere Konzentration an Phosphor aufweist als der Absorber (3).
